# FASCICULE DE BREVET EUROPEEN

(11) **EP 4 081 360 B1**
(45) Date de publication et mention de la délivrance du brevet: **29.01.2025**
(21) Numéro de dépôt: 20845587.3
(22) Date de dépôt: 15.12.2020
(51) Int. Cl.: B22C 9/04, B22C 9/22, B22C 9/24, B22D 19/04, B22D 19/16, B22D 21/02, B22D 27/04, C30B 29/52, C30B 11/00, C30B 29/60, C30B 29/66

(54) **PROCEDE DE FABRICATION D'AUBE DE TURBOMACHINE ET AUBE DE TURBOMACHINE**
VERFAHREN ZUR HERSTELLUNG EINER TURBINENLEITSCHAUFEL UND TURBINENLEITSCHAUFEL
METHOD FOR MANUFACTURING A TURBINE ENGINE VANE AND TURBINE ENGINE VANE

(30) Priorité: 23.12.2019 FR 1915444
(43) Date de publication de la demande: 02.11.2022
(73) Titulaire: Safran Helicopter Engines, 64510 Bordes (FR)
(72) Inventeur: BELAYGUE, Philippe Gabriel Louis, 77550 Moissy-Cramayel (FR); LARROUY, Baptiste Romain, 77550 Moissy-Cramayel (FR); BERTEAUX, Olivier Philippe David, 77550 Moissy-Cramayel (FR)
(74) Mandataire: Cabinet Beau de Loménie
(86) Numéro de dépôt international: PCT/FR2020/052459
(87) Numéro de publication internationale: WO 2021/130433

(56) Documents cités:
- EP-A2- 2 942 424
- FR-A1- 3 077 224
- US-A- 4 475 980
- US-A1- 2017 008 081

## Description

### Domaine Technique

Le présent exposé s'intéresse à la fabrication d'aubes pour des compresseurs ou des turbines de turbomachine. Le présent exposé s'applique particulièrement à la fabrication d'aubes de turbines haute-pression.

### Technique antérieure

Des procédés de fabrication d'aubes monocristallines de turbine haute pression par fonderie à cire perdue sont connus.

Ces procédés comprennent la formation d'un modèle d'aube en cire ou en résine, puis la formation d'un moule carapace en céramique autour de ce modèle d'aube par trempage et séchage successifs. La cire ou la résine est ensuite éliminée lors d'une étape de décirage, puis le moule carapace est fritté, laissant finalement le moule carapace creux. Un germe monocristallin est disposé dans le moule carapace et du métal liquide est coulé dans le moule carapace. Le moule carapace descend progressivement hors de la chambre chaude dans laquelle il est placé, ce qui entraine la solidification dirigée du métal liquide à partir du germe monocristallin. Ainsi, une aube monocristalline est formée.

Afin d'assurer de bonnes performances, le choix du matériau est un critère important. En effet, une aube monocristalline doit répondre à des contraintes spécifiques de fluage tout en restant la plus légère possible. Les contraintes de fluage comprennent les contraintes mécaniques et les contraintes de température qui s'imposent sur l'aube disposée dans une turbomachine en fonctionnement et que le matériau doit supporter. Par ailleurs, l'optimisation des coûts est un enjeu affectant également le choix du matériau.

Plus particulièrement, les aubes monocristallines obtenues par des procédés antérieurs ne permettent de fabriquer que des aubes monobloc et mono-matériau. De manière générale, les aubes comprennent une pale et un pied. Les caractéristiques du matériau sont donc imposées par les conditions les plus strictes subies par l'aube finalisée et disposée dans la turbomachine en fonctionnement. Par exemple, les contraintes subies par la pale d'une aube de turbomachine en fonctionnement sont plus importantes que les contraintes subies par le pied d'aube. Le matériau qui compose la pale, et donc l'aube, doit donc respecter un cahier des charges contraignant répondant à ces contraintes, ce qui le rend généralement plus onéreux et/ou plus lourd qu'un matériau devant répondre à des contraintes moins importantes.

Par conséquent, il existe un équilibre à trouver entre performance du matériau et le coût de l'aube. Des alliages ont été développés dans le but d'optimiser le cahier des charges des aubes monocristallines mais il reste encore de la marge pour des améliorations.

Plus particulièrement, il existe un besoin d'améliorer les procédés de fabrication des aubes.

On note par ailleurs que le présent exposé s'intéresse aux aubes fixes comme aux aubes mobiles. FR 3077224 divulgue un procédé de fabrication d'une aube monocristalline pour turbomachine. US 2017/008081 divulgue une méthode de coulée et de production d'articles moulés.

### Exposé de l'invention

Le présent exposé concerne un procédé de fabrication d'aube comprenant une première partie et une deuxième partie, le procédé tel que défini à la revendication 1 comprenant une étape de formation de la première partie comprenant la formation d'un modèle de première partie en matériau éliminable, puis la formation d'un premier moule carapace à partir du modèle de première partie, puis la formation de la première partie monocristalline ou colonnaire dans un premier alliage métallique dans le premier moule carapace à partir d'un sélecteur de grain, une étape de formation de la deuxième partie dans laquelle une deuxième partie est formée sur la première partie, et dans lequel la première partie et la deuxième partie sont prévus dans des matériaux différents, la deuxième partie étant formée polycristalline dans un deuxième alliage métallique.

On comprend que la partie polycristalline n'est pas une partie dont la croissance est dirigée (monocristalline ou colonnaire). Les parties polycristallines peuvent donc comporter une pluralité de grains dirigés aléatoirement dans toutes les directions.

Dans le présent exposé, on peut donner comme exemple non limitatif de matériau éliminable de la cire ou de la résine.

Dans certains modes de réalisations, la première partie est une pale et la deuxième partie est un pied.

Dans une turbomachine en fonctionnement, le pied et la pale d'une aube ne subissent pas les mêmes contraintes. En choisissant la pale comme première partie et le pied d'aube comme deuxième partie permet de pouvoir prévoir des cahiers des charges séparés pour les matériaux composant ces deux parties, chacun adaptés spécifiquement à l'environnement subit par la pale ou le pied, respectivement.

Un tel procédé permet de concevoir une aube de turbomachine avec un pied et une pale dans des matériaux optimisés différemment. Il est donc possible de répondre à un cahier des charges exigeant, en particulier pour les propriétés en fluage pour le matériau qui compose la pale, tout en utilisant un matériau répondant à un cahier des charges moins exigeant pour former le pied. Plus particulièrement, en opposition aux aubes monocristallines ou aux aubes à structure colonnaire connues de l'art, l'obtention d'aubes en partie polycristallines est plus rapide et bien moins coûteux.

Il est donc possible, à l'aide de ce procédé, d'optimiser à la fois les propriétés en fluage et le coût d'une aube monocristalline/colonnaire sans interférer avec ses performances voire même en l'allégeant. Plus particulièrement, il est possible d'optimiser indépendamment le matériau qui compose la pale de l'aube et le matériau qui compose le pied de l'aube, sachant que ces deux éléments ne sont pas amenés à subir les mêmes contraintes une fois que l'aube est disposée dans une turbomachine en fonctionnement.

Par ailleurs, ce procédé permet de fabriquer une aube comprenant des parties prévues dans des matériaux différents sans nécessiter de soudure, de collage, ou plus généralement d'étape d'assemblage. Le procédé est plus simple, plus rapide mais surtout plus performant en particulier sur la tenue de la liaison entre les deux matériaux, grâce notamment à des phénomènes diffusifs.

De plus, dans les procédés connus, il est nécessaire que l'aube soit entièrement monocristalline/colonnaire pour des raisons de résistance de l'aube finalisée. En particulier, dans une aube monocristalline/colonnaire, la présence de grains polycristallins, par exemple équiaxes, dans la pale de l'aube pourrait fragiliser l'aube en créant des interfaces appelées joints de grains où des fissures peuvent se propager plus facilement et donc engendrer un risque de rupture de l'aube. Cependant, ce risque concerne essentiellement la pale, qui subit les contraintes les plus fortes. Le présent procédé contourne ce risque en séparant l'aube en deux parties.

Dans certains modes de réalisations, la première partie et la deuxième partie sont formées dans deux alliages à base de nickel différents.

Dans le présent exposé, un alliage à base de nickel est un alliage dont le nickel est l'élément présentant la fraction massique majoritaire, de préférence supérieure à 40%.

Dans cette configuration, il est possible de prévoir deux matériaux aux propriétés différentes, l'un composant la pale et l'autre le pied, chacun étant optimisé en fonction de l'environnement et des contraintes qu'il subit dans une turbomachine en fonctionnement. L'utilisation d'un alliage de même base nickel pour la première et la deuxième partie permet par ailleurs d'assurer une bonne liaison métallurgique (parfaite épitaxie) entre ces deux parties.

Le procédé comprend au moins une étape de traitement après l'étape de formation de la deuxième partie.

Cette étape de traitement permet d'optimiser les caractéristiques mécaniques des matériaux composant l'aube de turbomachine.

L'alliage polycristallin formant la deuxième partie présente une température de solvus T_{γ'} correspondant à la température de solvus des précipités γ' dans l'alliage. L'étape de traitement peut alors comprendre deux étapes de traitement thermique, la première étape s'effectuant à une température comprise entre 95% et 105% de la température de solvus T_{γ'} et la deuxième étape s'effectuant à une température comprise entre 65% et 75% de la température de solvus T_{γ'}.

Dans la configuration des précédents exemples, lors de la première étape de traitement thermique, la première partie monocristalline subit un traitement de vieillissement tandis que la deuxième partie polycristalline subit un traitement de mise en solution. Ainsi, ces deux traitements sont opérés en une unique première étape de traitement thermique, ce qui représente un gain de temps et de moyens.

De plus, pendant la seconde étape de traitement thermique, la première partie monocristalline subit un deuxième traitement de vieillissement et la deuxième partie polycristalline subit un traitement de vieillissement. De la même manière que lors de la première étape de traitement thermique, ces deux traitements sont opérés en une unique seconde étape de traitement thermique. Cela représente donc un gain de temps et de moyens.

Dans certains modes de réalisations, l'étape de formation de la deuxième partie comprend la formation de la deuxième partie dans le deuxième alliage métallique sur la première partie par une méthode de formation additive sur lit de poudre.

Dans cette configuration, il est possible de prévoir le pied d'aube à l'aide d'un procédé indépendant du procédé de formation de la pale, tout en l'additionnant directement sur la pale. Cette opération est moins coûteuse et plus rapide qu'une étape de fonderie. Comme méthode de formation additive sur lit de poudre, on peut citer par exemple la méthode de fabrication additive sur lit de poudre appelé SLM (conformément au sigle anglais pour Selective Laser Melting).

Ce procédé est un procédé au cours duquel, une pièce tridimensionnelle est réalisée, couche après couche, par fusion au moins partielle localement d'une ou plusieurs couche(s) de poudre par un laser qui balaye la couche de poudre aux endroits où l'on souhaite faire fondre la poudre. Lorsqu'une couche a été balayée par le laser, une nouvelle couche de poudre est déposée sur la couche qui vient d'être balayée et la nouvelle couche est balayée par le laser. La pièce est ainsi construite couche après couche.

Ce procédé permet un gain en termes de coûts, de délais de fabrication, tout en garantissant des propriétés mécaniques pouvant approcher celles obtenues avec les procédés traditionnels, tels que le forgeage, ou celles de la fonderie.

En effet, la fabrication additive sur lit de poudre permet de s'affranchir de la nécessité de fabriquer des moules et/ou de souder et/ou d'assembler différents éléments pour former la pièce désirée. Il est donc plus simple de passer de l'étape de conception à l'étape de production de la pièce.

Dans certains modes de réalisations, le procédé comprend une étape d'usinage de jonction après l'étape de formation de la deuxième partie.

Ainsi, il est possible d'ajuster le pied, voire le profil de l'aube, et de corriger les éventuelles imperfections générées par la méthode de formation additive sur lit de poudre.

Dans certains modes de réalisations, l'étape de formation de la deuxième partie comprend la formation d'un modèle de deuxième partie en matériau éliminable, puis la formation d'un deuxième moule carapace à partir du modèle de deuxième partie, puis la formation de la deuxième partie dans le deuxième alliage métallique dans le deuxième moule carapace.

Cette configuration donne une alternative à la formation d'un pied d'aube et d'une pale de manière indépendante.

Dans certains modes de réalisations, l'étape de formation de la deuxième partie comprend une étape refroidissement équiaxe.

Ainsi, l'étape de refroidissement est rapide et aboutit la formation d'un pied polycristallin. Cette étape représente donc un gain de temps par rapport à une étape de refroidissement dirigée, nécessaire dans les protocoles connus de formation d'aubes monocristallines/colonnaires.

Dans certains modes de réalisations, la partie de jonction de la première partie est refondue lors de l'étape de formation de la deuxième partie

Dans cette configuration, la liaison métallurgique entre la première partie et la deuxième partie est améliorée.

Le présent exposé concerne par ailleurs une aube comprenant une première partie monocristalline ou colonnaire dans un premier alliage métallique et une deuxième partie polycristalline dans un deuxième alliage métallique différent du premier alliage métallique.

Une telle aube présente les avantages cités précédemment.

Dans certains modes de réalisations, l'aube est obtenue par un des procédés précédemment décrits.

Dans certains modes de réalisations, la deuxième partie et la première partie de l'aube sont formées dans deux alliages à base de nickel différents.

### Brève description des dessins

L'invention et ses avantages seront mieux compris à la lecture de la description détaillée faite ci-après de différents modes de réalisation de l'invention donnés à titre d'exemples non limitatifs. Cette description fait référence aux pages de figures annexées, sur lesquelles :
[Fig. 1] La figure 1 représente une aube monocristalline ou colonnaire obtenue par un procédé selon un mode de réalisation.
[Fig. 2] La figure 2 représente une pale monocristalline ou colonnaire obtenue par un procédé selon un mode de réalisation, disposée un deuxième moule carapace.
[Fig. 3] La figure 3 représente un deuxième moule carapace selon un deuxième mode de réalisation du procédé formé autour d'une d'aube.
[Fig. 4] La figure 4 représente schématiquement les étapes du procédé selon les différents modes de réalisation.

### Description des modes de réalisation

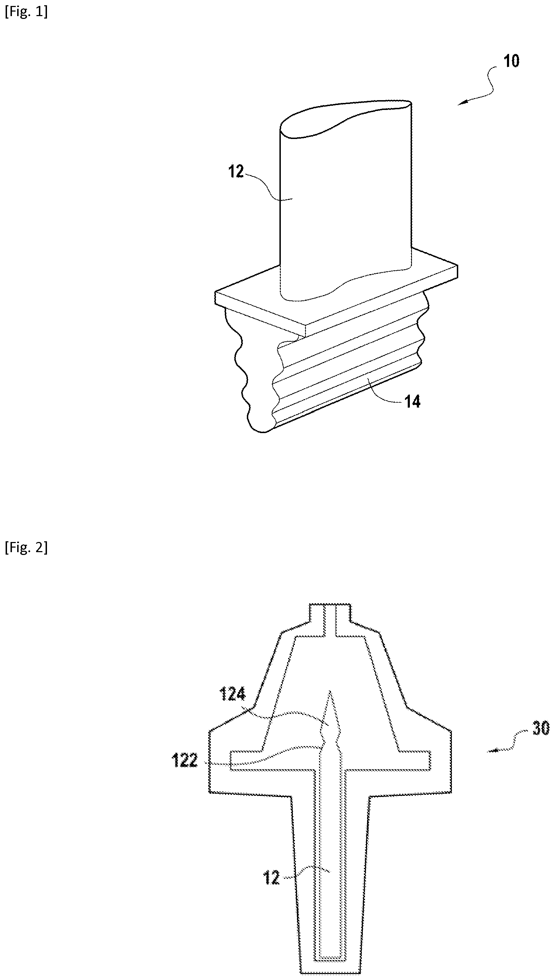

La figure 1 représente une aube 10 comprenant une pale 12 et un pied 14. La pale 12 et le pied 14 sont formés dans des alliages métalliques différents. A titre d'exemple non limitatif, la pale 12 et le pied 14 sont formés dans des alliages à base de nickel. En particulier, le pied 14 peut être polycristallin dans un alliage moins cher et/ou plus léger que l'alliage de la pale 12. Dans le cas où le pied est polycristallin, il peut présenter une température de solvus T_{γ'} correspondant à la température de solvus des précipités γ' dans l'alliage qui compose le pied 14.

Dans les modes de réalisation décrits, une première partie correspond à la pale 12 et une seconde partie correspond au pied 14. Cependant, il est possible de subdiviser l'aube d'une autre façon, avec une première partie et une seconde partie qui ne correspondent pas nécessairement à la pale 12 et au pied 14. En particulier, le niveau de chargement thermomécanique de la pale à former ainsi que son procédé de fabrication associé conditionne le positionnement de la jonction.

Par ailleurs, l'aube 10 peut comprendre une plateforme qui correspond à une partie plane s'étendant au niveau du contact entre le pied 14 et l'aube 12. Ainsi, en fonction des besoins, il est possible d'inclure la plateforme dans la première partie ou dans la deuxième partie. Il est aussi possible de prévoir une partie de la plateforme sur la première partie de l'aube 10 et une seconde partie de la plateforme sur la deuxième partie de l'aube 10.

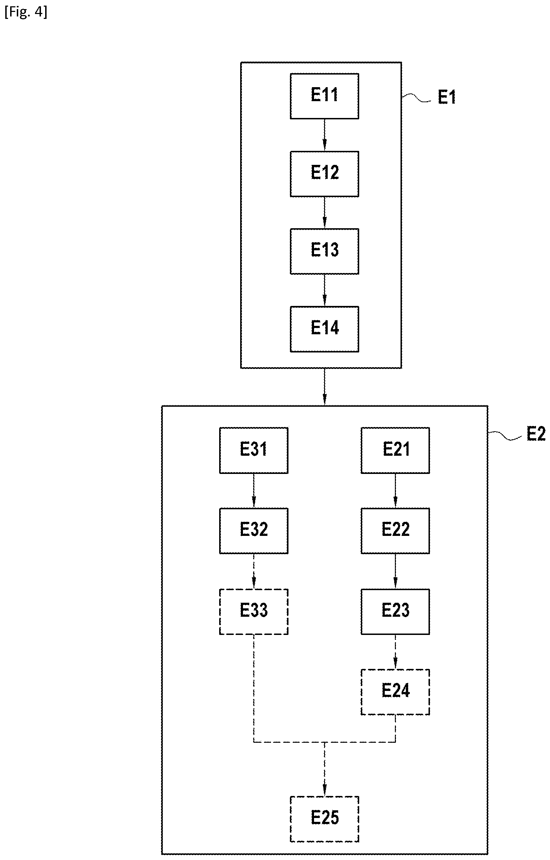

Cette aube 10 est obtenue par un procédé comme schématisé sur la figure 4, comprenant une étape de formation de pale (ou étape de formation de la première partie) E1, dans laquelle la pale 12 monocristalline est formée suivie d'une étape de formation de deuxième partie E2 dans lequel le pied 14 est formé.

L'étape de formation de pale E1 comprend une étape de formation d'un modèle de pale en matériau éliminable E11, suivie d'une étape de formation d'un premier moule carapace E12 dans laquelle un premier moule carapace est formé à l'aide du modèle de pale formé pendant l'étape E11 par trempage et séchage successif, puis le premier moule carapace est déciré et fritté. L'étape de formation de pale E1 comprend ensuite une étape de coulée E13 dans laquelle un sélecteur de grain est disposé dans le premier moule carapace et du métal liquide, destiné à former le premier alliage métallique, est coulé dans le premier moule carapace alors disposé dans une chambre chaude. Enfin, l'étape de formation de pale E1 comprend une étape de solidification dirigée E14 effectuée dans la chambre chaude, dans laquelle le premier moule carapace est lentement retiré de la chambre chaude pour former la pale 12 monocristalline à partir du sélecteur de grain.

Dans certaines configurations, la pale 12 est formée de façon colonnaire. Dans cette configuration, la pale 12 est composée de grains dont la cristallisation est dirigée dans une direction préférentielle, à partir de la direction préférentielle des grains du sélecteur de grain.

De manière connue, la pale 12 peut subir un traitement thermique d'homogénéisation de la chimie entre dendrite et interdendrites. Cela permet aussi le contrôle de la distribution des précipités dans la pale 12. Par exemple, la pale 12 peut subir un traitement thermique à une température comprise entre 110% et 115% de la température de solvus T_{γ'}. Dans le présent exemple, cette plage correspond ici à la plage 1260°C à 1330°C.

Ce procédé de formation de pale E1, permettant de former la pale 12, est commun et préalable aux deux modes de réalisation de l'étape de formation de deuxième partie E2 suivants. De plus, dans les modes de réalisations suivants, à titre d'exemple non limitatif, le matériau utilisé pour former la pale 12 est l'alliage à base de nickel CMSX4 ^{®}.

### Formation du pied par une méthode additive sur lit de poudre

Dans un premier mode de réalisation, le pied 14 est formé par addition sur la pale 12. En référence à la partie de gauche de la figure 4, le pied 14 est formé lors d'une étape de formation de la deuxième partie E2 commençant par une étape de formation de pied E31. Le pied 14 est formé sur la pale 12 monocristalline à l'aide d'un procédé de fusion sélective par laser (de l'anglais SLM). Lors de cette étape, le pied 14 est formé couche par couche à partir d'un lit de poudre métallique dans lequel la pale 12 est plongée. Le laser fusionne sélectivement les grains de poudre en balayant le lit selon le profil du pied 14, formant ainsi le pied 14 lorsque les grains fusionnent puis se solidifient. Le pied 14 ainsi formé est polycristallin.

Ensuite, le pied 14 formé subit une étape de compression isostatique à chaud E32. Cette étape permet d'augmenter la densité du pied 14 qui a été formé. Dans le présent exemple, la compression isostatique à chaud s'effectue entre 1130°C et 1190°C et s'ensuit d'un refroidissement lent jusqu'à 1050°C et 1100°C.

Puis, l'aube 10 formée peut être usinée lors d'une étape d'usinage E33. Lors de cette étape, la conformation et l'état de surface du pied E31 sont ajustés. L'aube 10 est alors mise en conformité avec le profil souhaité. En particulier, le pied et/ou la jonction peuvent être usinés.

Dans ce mode de réalisation, à titre d'exemple non limitatif, le matériau utilisé pour former le pied 14 est l'alliage à base de nickel René ^{®} 77.

Dans ce mode de réalisation, la pale 12 peut comprendre une partie de la plateforme de l'aube 10 tandis que le pied comprend l'autre partie de la plateforme de l'aube 10. Par ailleurs, il est possible de séparer la première partie et la deuxième partie au-dessus ou en dessous de la plateforme. La jonction entre la première partie et la deuxième partie peut donc se situer dans la pale ou le pied.

Pour obtenir un état de surface souhaité une étape de fonderie peut être prévue après l'étape de formation de la deuxième partie E2. Cette étape consiste à une refusion partielle dans un moule du pied 14. Cette étape supplémentaire a pour avantage d'améliorer l'état de surface du pied 14 en homogénéisant les éventuelles irrégularités de surfaces engendrées par les passages successifs du laser (notamment dans les zones dites downskin, qui sont des zones n'ayant pas de matière solide comme support lors de leur formation). Elle permet également de réaliser la zone en fabrication additive avec un laser moins fin et moins focalisé, ce qui diminue donc les temps de production.

### Formation du pied par une méthode de fonderie à cire perdue

Dans un deuxième mode de réalisation, le pied 14 est formé par un procédé de fonderie à cire perdue. En référence à la partie droite de la figure 4, l'étape de formation de la deuxième partie E2 comprend une étape de formation d'un modèle d'aube E21 en matériau éliminable dans laquelle un modèle de pied est formé sur la pale 12 formée lors de l'étape de formation de pale E1. Le modèle de pied en matériau éliminable et la pale 12 forment donc un modèle d'aube. L'étape de formation d'un modèle d'aube E21 est suivie d'une étape de formation d'un deuxième moule carapace E22 dans laquelle un deuxième moule carapace 30 est formé à l'aide du modèle d'aube par trempage et séchage successif, puis le deuxième moule carapace 30 est déciré et fritté.

Dans ce mode de réalisation, la pale 12 est maintenue en place dans le deuxième moule carapace 30 lors de ces étapes. L'étape de formation de pied E2 comprend ensuite une étape de coulée de l'aube E23, en particulier du pied 14 d'aube, dans laquelle du métal liquide, destiné à former le deuxième alliage métallique, est coulé dans le deuxième moule carapace 30 alors disposé dans une chambre chaude. Enfin, l'étape de formation de pied E2 comprend une étape de solidification équiaxe E24 du pied 14 d'aube effectuée dans la chambre chaude, dans laquelle le deuxième moule carapace 30 est rapidement retiré de la chambre chaude pour former l'aube 10 à partir de la pale 12 monocristalline et du pied 14 polycristallin.

La figure 2 représente le modèle d'aube obtenu après l'étape de formation d'un modèle d'aube E21 selon un mode de réalisation. Comme représenté sur la figure 2, la pale 12 formée lors de l'étape de formation E1 comprend une partie d'accroche 122 et une partie d'extrémité conique 124. La partie d'extrémité conique 124 est prévue à l'extrémité de la pale 12 qui est amenée à être en contact avec le pied 14 à former.

La partie d'extrémité conique 124 est la partie de la pale 12 qui est refondue lors de l'étape de coulée de l'aube E23. Cela permet d'assurer une épitaxie quasi-parfaite entre la pale 12 et le pied 14. En effet, lors de l'étape de coulée de l'aube E23, seule la partie supérieure du deuxième moule carapace 30 est disposée dans la chambre chaude, c'est-à-dire la partie correspondant au pied 14.

La partie d'accroche 122 est configurée pour que le modèle de pied formé lors de l'étape de formation du modèle d'aube E21 puisse être positionné précisément autour de la pale 12 et pour assurer une bonne fixation entre le modèle de pied et la pale 12.

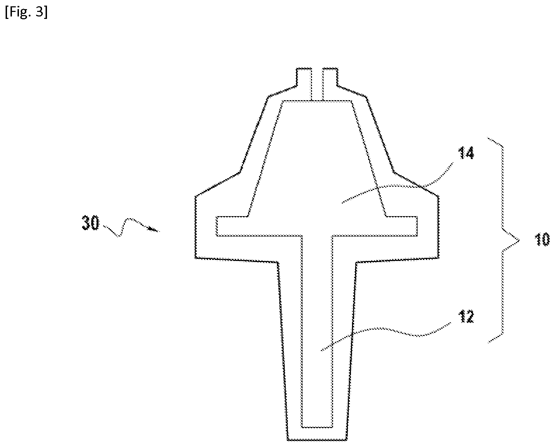

La figure 3 représente l'aube 10 obtenue après l'étape de solidification équiaxe E24 du pied 14 sur la pale 12. Dans le deuxième moule carapace 30, l'aube 10 présente donc deux parties : la pale 12 monocristalline et le pied 14 polycrisallin. La partie d'extrémité conique 124 de la pale 12 a été refondue avec le pied 14.

Dans ce mode de réalisation, à titre d'exemple non limitatif, le matériau utilisé pour former le pied 14 est l'alliage à base de nickel Inconel ^{®} 792.

Dans ce mode de réalisation, le pied 14 peut comprendre l'intégralité de la plateforme de l'aube 10.

Facultativement, l'aube 10 finalisée obtenue par l'un des modes de réalisation précédemment décrits peut subir une étape de traitement E25. Ce traitement peut comprendre un traitement thermique et/ou le dépôt de couches additionnelles. Il peut s'additionner au traitement thermique de d'homogénéisation de la pale 12.

Dans le premier et le deuxième mode de réalisation, l'étape de traitement E25 peut comprendre en premier lieu une étape de dépôt d'une couche anti-oxydation. Dans le cas présent, à titre d'exemple non limitatif, cette couche est une couche de NiCoCrAIYTa, qui est déposée au moins sur la pale 12 de l'aube 10.

Ensuite, dans une première étape de traitement thermique, l'aube 10 subit un traitement thermique dans lequel l'aube 10 est chauffée entre 1080°C et 1100°C pendant 4 heures, puis refroidie à l'air. Ce traitement permet la diffusion de la couche anti-oxydation dans les matériaux composant l'aube 10. Dans le cas où l'aube comprend du Inconel ^{®} 792, ce traitement permet également sa mise en solution.

Plus généralement, dans cette première étape de traitement thermique, la température à laquelle l'aube 10 est chauffée est comprise entre 95% et 105% de la température de solvus T_{γ'}. Dans le présent exemple, cette plage correspond ici à une plage comprise entre 1080°C et 1180°C. Pendant cette étape, la pale 12 monocristalline subit un traitement de vieillissement tandis que le pied 14 polycristallin subit un traitement de mise en solution. Ainsi, ces deux traitements sont opérés en une unique première étape de traitement thermique, ce qui représente un gain de temps et de moyens.

Ensuite, dans une seconde étape de traitement thermique, l'aube 10 peut subir un traitement entre 840°C et 870°C pendant 20 à 24 heures, suivi d'un refroidissement à l'air. Cette étape permet le vieillissement des matériaux qui composent l'aube 10.

Plus généralement, lors de la seconde étape de traitement thermique, l'aube 10 est chauffée à une température comprise entre 65% et 75% de la température de solvus T_{γ'}. Dans le présent exemple, cette plage correspond ici à une plage comprise entre 750°C et 880°C. Pendant cette étape, la pale 12 subit un deuxième traitement de vieillissement et le pied 14 polycristallin subit un traitement de vieillissement. De la même manière que lors de la première étape de traitement thermique, ces deux traitements sont opérés en une unique seconde étape de traitement thermique. Cela représente donc un gain de temps et de moyens.

Par ailleurs, l'étape de traitement E25 peut comprendre la déposition d'un revêtement abrasif sur la tête de l'aube, à l'extrémité distale de la pale 12. L'extrémité distale est entendue comme l'extrémité de la pale 12 qui n'est pas en contact avec le pied 14. Dans cet exemple, le revêtement abrasif est un dépôt de zircone.

Bien que la présente invention ait été décrite en se référant à des exemples de réalisation spécifiques, il est évident que des modifications et des changements peuvent être effectués sur ces exemples sans sortir de la portée générale de l'invention telle que définie par les revendications. En particulier, des caractéristiques individuelles des différents modes de réalisation illustrés/mentionnés peuvent être combinées dans des modes de réalisation additionnels, les matériaux peuvent être modifiés ainsi que leur traitement thermique. Typiquement, la partie polycristalline peut être réalisée par métallurgie des poudres, ou tout autre procédé de fabrication. Par conséquent, la description et les dessins doivent être considérés dans un sens illustratif plutôt que restrictif.

Il est également évident que toutes les caractéristiques décrites en référence à un procédé sont transposables, seules ou en combinaison, à un dispositif, et inversement, toutes les caractéristiques décrites en référence à un dispositif sont transposables, seules ou en combinaison, en se limitant à un procédé comme décrit dans les revendications 1 - 10.

## Revendications

1. Procédé de fabrication d'aube (10) comprenant une première partie et une deuxième partie, le procédé comprenant
une étape de formation de la première partie (E1) comprenant la formation d'un modèle de première partie en matériau éliminable, puis la formation d'un premier moule carapace à partir du modèle de première partie, puis la formation de la première partie monocristalline ou colonnaire dans un premier alliage métallique dans le premier moule carapace à partir d'un sélecteur de grain,
une étape de formation de la deuxième partie (E2) dans laquelle une deuxième partie est formée sur la première partie,
la première partie et la deuxième partie sont prévus dans des matériaux différents, la deuxième partie étant formée polycristalline dans un deuxième alliage métallique,
le procédé étant **caractérisé en ce qu'**il comprend au moins une étape de traitement (E25) après l'étape de formation de la deuxième partie (E2),
l'étape de traitement (E25) comprenant une première étape de traitement thermique dans laquelle l'aube (10) est chauffée à une température comprise entre 95% et 105% de la température de solvus (T_{γ'}) de la deuxième partie polycristalline et une seconde étape de traitement thermique dans laquelle l'aube (10) est chauffée à une température comprise entre 65% et 75% de la température de solvus (T_{γ'}).

2. Procédé selon la revendication 1, dans lequel la première partie est une pale (12) et la deuxième partie est un pied (14).

3. Procédé selon l'une des revendications 1 ou 2, dans laquelle la première partie (14) et la deuxième partie (12) sont formées dans deux alliages à base de nickel différents.

4. Procédé selon l'une des revendications 1 à 3 dans lequel l'étape de formation de la deuxième partie (E2) comprend la formation de la deuxième partie dans le deuxième alliage métallique sur la première partie par une méthode de formation additive sur lit de poudre.

5. Procédé selon la revendication 4, comprenant une étape d'usinage de jonction après l'étape de formation de la deuxième partie.

6. Procédé selon l'une des revendications 1 à 3, dans lequel l'étape de formation de la deuxième partie (E2) comprend la formation d'un modèle de deuxième partie en matériau éliminable, puis la formation d'un deuxième moule carapace à partir du modèle de deuxième partie, puis la formation de la deuxième partie dans le deuxième alliage métallique dans le deuxième moule carapace (30).

7. Procédé selon la revendication 6, dans lequel l'étape de formation de la deuxième partie (E2) comprend une étape refroidissement équiaxe.

8. Procédé selon l'une des revendications 6 ou 7, dans lequel la partie de jonction de la première partie est refondue lors de l'étape de formation de la deuxième partie.

9. Aube (10) comprenant une première partie monocristalline ou colonnaire dans un premier alliage métallique et une deuxième partie polycristalline dans un deuxième alliage métallique différent du premier alliage métallique, l'aube étant obtenue par un procédé selon l'une des revendications 1 à 8.

10. Aube (10) selon l'une des revendications 8 ou 9, dans laquelle la première partie et la deuxième partie sont formées dans deux alliages à base de nickel différents.

## Patentansprüche

1. Verfahren zur Herstellung einer Leitschaufel (10), umfassend einen ersten Teil und einen zweiten Teil, wobei das Verfahren Folgendes umfasst:
einen Schritt des Bildens des ersten Teils (E1), umfassend das Bilden eines Modells des ersten Teils aus entfernbarem Material, dann das Bilden einer ersten Schalenform auf der Grundlage des Modells des ersten Teils, dann das Bilden des ersten monokristallinen oder säulenförmigen Teils aus einer ersten Metalllegierung in der ersten Schalenform auf der Grundlage einer Korngrößen-Auswahlvorrichtung,
einen Schritt des Bildens des zweiten Teils (E2), wobei der zweite Teil auf dem ersten Teil gebildet wird, der erste Teil und der zweite Teil aus verschiedenen Materialien vorgesehen sind, wobei der zweite Teil polykristallin aus einer zweiten Metalllegierung gebildet ist,
wobei das Verfahren **dadurch gekennzeichnet ist, dass** es mindestens einen Schritt des Behandelns (E25) nach dem Schritt des Bildens des zweiten Teils (E2) umfasst,
wobei der Schritt des Behandelns (E25) einen ersten Schritt des thermischen Behandelns umfasst, in dem die Leitschaufel (10) auf eine Temperatur im Bereich zwischen 95 % und 105 % der Solvustemperatur (T*_{γ'}*) des zweiten polykristallinen Teils erhitzt wird, und einen zweiten Schritt des thermischen Behandelns, in dem die Leitschaufel (10) auf eine Temperatur im Bereich zwischen 65 % und 75 % der Solvustemperatur (T*_{γ'}*) erhitzt wird.

2. Verfahren nach Anspruch 1, wobei der erste Teil ein Blatt (12) ist und der zweite Teil ein Fuß (14) ist.

3. Verfahren nach einem der Ansprüche 1 oder 2, wobei der erste Teil (14) und der zweite Teil (12) aus zwei verschiedenen Legierungen auf der Grundlage von Nickel gebildet sind.

4. Verfahren nach einem der Ansprüche 1 bis 3, wobei der Schritt des Bildens des zweiten Teils (E2) das Bilden des zweiten Teils aus der zweiten Metalllegierung auf dem ersten Teil durch ein Verfahren des additiven Bildens auf einem Pulverbett umfasst.

5. Verfahren nach Anspruch 4, umfassend einen Schritt des Bearbeitens der Verbindung nach dem Schritt des Bildens des zweiten Teils.

6. Verfahren nach einem der Ansprüche 1 bis 3, wobei der Schritt des Bildens des zweiten Teils (E2) das Bilden eines Modells des zweiten Teils aus entfernbarem Material, dann das Bilden einer zweiten Schalenform auf der Grundlage des Modells des zweiten Teils, dann das Bilden des zweiten Teils aus der zweiten Metalllegierung in der zweiten Schalenform (30) umfasst.

7. Verfahren nach Anspruch 6, wobei der Schritt des Bildens des zweiten Teils (E2) einen Schritt es gleichachsigen Abkühlens umfasst.

8. Verfahren nach einem der Ansprüche 6 oder 7, wobei der Verbindungsteil des ersten Teils beim Schritt des Bildens des zweiten Teils umgearbeitet wird.

9. Leitschaufel (10), umfassend einen ersten monokristallinen oder säulenförmigen Teil aus einer ersten Metalllegierung und einen zweiten polykristallinen Teil aus einer zweiten Metalllegierung, die verschieden von der ersten Metalllegierung ist, wobei die Leitschaufel durch ein Verfahren nach einem der Ansprüche 1 bis 8 erhalten wird.

10. Leitschaufel (10) nach einem der Ansprüche 8 oder 9, wobei der erste Teil und der zweite Teil aus zwei verschiedenen Legierungen auf der Grundlage von Nickel gebildet sind.

## Claims

1. Method for manufacturing a blade (10) comprising a first portion and a second portion, the method comprising
a step of forming the first portion that comprises forming a model of the first portion (E1) from removable material, then forming a first shell mould from the model of the first portion, then forming the single-crystal or columnar first portion from a first metal alloy in the first shell mould from a grain selector,
a step of forming the second portion (E2) in which a second portion is formed on the first portion, and
wherein the first portion and the second portion are made from different materials, the second portion being polycrystalline and formed from a second metal alloy,
the method being **characterized in that** it comprises at least one treatment step (E25) after the step of forming the second portion (E2),
the treatment step (E25) comprising a first heat treatment step, in which the blade (10) is heated to a temperature between 95% and 105% of the solvus temperature (T_{γ'}) of the second polycrystalline portion and a second heat treatment step in which the blade (10) is heated to a temperature between 65% and 75% of the solvus temperature (T_{γ'}).

2. Method according to claim 1, wherein the first portion is an aerofoil (12) and the second portion is a root (14).

3. Method according to claim 1 or 2, wherein the first portion (12) and the second portion (14) are formed from two different nickel-based alloys.

4. Method according to any of claims 1 to 3, wherein the step of forming the second portion comprises the forming of the second portion (E2) from the second metal alloy on the first portion by a powder bed fusion method.

5. Method according to claim 4, comprising a step of junction machining after the step of forming the second portion.

6. Method according to any of claims 1 to 3, wherein the step of forming the second portion (E2) comprises the forming of a model of the second portion made of removable material, then forming a second shell mould on the basis of the second portion model, then forming the second portion from the second metal alloy in the second shell mould (30).

7. Method according to claim 6, wherein the step of forming the second portion (E2) comprises an equiaxed cooling step.

8. Method according to claim 6 or 7, wherein the junction portion of the first portion is remelted during the step of forming the second portion.

9. Blade (10) comprising a single-crystal or columnar first portion made from a first metal alloy and a polycrystalline second portion made from a second metal alloy different from the first metal alloy, the blade being obtained by a method according to any of claims 1 to 8.

10. Blade (10) according to claim 9 or 10, wherein the first portion and the second portion are formed from two different nickel-based alloys.
